# EUROPEAN PATENT SPECIFICATION

(11) **EP 3 869 931 B1**
(45) Date of publication and mention of the grant of the patent: **05.03.2025**
(21) Application number: 18937293.1
(22) Date of filing: 16.10.2018
(51) Int. Cl.: H05K 13/08, H04N 5/76, H04N 21/4335, H04N 21/231

(54) **DATA MANAGEMENT DEVICE AND DATA MANAGEMENT METHOD**
DATENVERWALTUNGSVORRICHTUNG UND DATENVERWALTUNGSVERFAHREN
DISPOSITIF DE GESTION DE DONNÉES ET PROCÉDÉ DE GESTION DE DONNÉES

(43) Date of publication of application: 25.08.2021
(73) Proprietor: Fuji Corporation, Chiryu-shi, Aichi 472-8686 (JP)
(72) Inventor: OIKE, Hiroshi, Chiryu-shi, Aichi 472-8686 (JP); KITO, Shuichiro, Chiryu-shi, Aichi 472-8686 (JP); SUZUKI, Mikiya, Chiryu-shi, Aichi 472-8686 (JP)
(74) Representative: Grünecker Patent- und Rechtsanwälte PartG mbB
(86) International application number: PCT/JP2018/038497
(87) International publication number: WO 2020/079753

(56) References cited:
- EP-A2- 1 231 786
- WO-A1-2012/111202
- CN-A- 107 562 810
- DE-T5- 112011 104 888
- JP-A- 2006 332 402
- JP-A- 2006 332 402
- JP-A- 2008 085 559
- JP-A- 2013 074 575
- JP-A- H04 242 122
- US-A1- 2017 344 308

## Description

### Technical Field

The present specification discloses techniques related to a data management device and a data management method.

### Background Art

A component mounter disclosed in Patent Literature 1 temporarily stores all image data in a storage section, and deletes the image data in order from the image data having a low priority in a case in which there is no empty space in a storage area. The priority is set such that the image data to be possibly deleted is deleted in order from the oldest data, while in a case in which there is no image data that can be deleted, the image data in a lock target (a sort of image data targeted for storage) is deleted in order from the oldest data.

### Patent Literature

Patent Literature 1: WO 2012/111202

DE 11 2011 104888 T5 discloses a component-mounting machine equipped with: a substrate transport device; a component supply device; a component transfer device; and an image monitoring device, which has an imaging unit that obtains image data by capturing an image when a suction nozzle has picked up a component, a storage unit that saves the image data, and a determination unit that determines the state of the suction nozzle with respect to the picking up of a component and determines component defects on the basis of the image data.

JPH04 242122 A discloses deleting test data for which the storage period has expired, or deleting test data for which the storage period has expired, except for data relating to bad test results.

EP 1 231 786 A2 discloses a system for optimizing the use and availability of storage space in a video data recording system. An intelligent disk recording and management system selectively assigns tags to determine the manner and/or priority of recording programs onto a storage device and the priority of maintaining the programs on the storage device once the programs are recorded.

JP 2006 332402 A discloses an electronic component mount apparatus that backs up data associated with mount of various electronic components periodically by each setting period and can restore present data contents into data contents before revision, by using the backed-up data so as to prevent mount precision of electronic components from being deteriorated.

JP 2008/085559 A discloses a method for storing an image used for an inspection in a predetermined storage medium in an appearance inspection for determining the quality of an inspection object by imaging the inspection object and processing the generated image.

CN 107 562 810 A discloses a video big data hierarchical storage method.

It is the object of the present invention to provide an improved device and method for efficiently investigating problems of a board work.

This object is solved by the subject matter of the independent claims.

Embodiments are defined in the dependent claims.

### Technical Problem

The component mounter disclosed in Patent Literature 1 temporarily stores all image data in the storage section, however, it does not provide information regarding a component mounting work to the image data, and does not set a maximum storage amount for each information in order to store and manage the image data.

In view of the above circumstances, the present specification discloses a data management device and a data management method capable of storing and managing the acquired data, being related to the board work performed by a board work machine, which are different from the conventional art.

### Advantageous Effect of the Invention

With the data management device, the data management section and the priority setting section is provided. As a result, the data management device can provide at least one piece of additional information regarding the board work to the acquired data acquired related to the board work, set the maximum storage amount for each additional information, and store and manage the acquired data. The above description of the data management device can be similarly applied to the data management method.

### Brief Description of Drawings

Fig. 1 is a configuration diagram showing a configuration example of board work line WML.
Fig. 2 is a plan view showing a configuration example of component mounter WM3.
Fig. 3 is a block diagram showing an example of a control block of data management device 80.
Fig. 4 is a schematic diagram showing an example of a storage method of image data acquired by imaging component 91 held by holding member 30 by part camera 14.
Fig. 5 is a flowchart showing an example of a control procedure performed by data management section 81.
Fig. 6A is a schematic diagram showing an example of a relationship between maximum storage number Npa set for component type PA that is additional information and the image data stored in storage device DB.
Fig. 6B is a schematic diagram showing an example of a relationship between maximum storage number Nn1 set for holding member 30 specified by identification information N1 that is the additional information and the image data stored in storage device DB.
Fig. 6C is a schematic diagram showing an example of a relationship between maximum storage number Nok set for a work result (good) that is the additional information and the image data stored in storage device DB.
Fig. 6D is a schematic diagram showing an example of a relationship between maximum storage number Nng set for a work result (bad) that is the additional information and the image data stored in storage device DB.

### Description of Embodiments

### 1. Embodiment

### 1-1. Configuration Example of Board Work Line WML

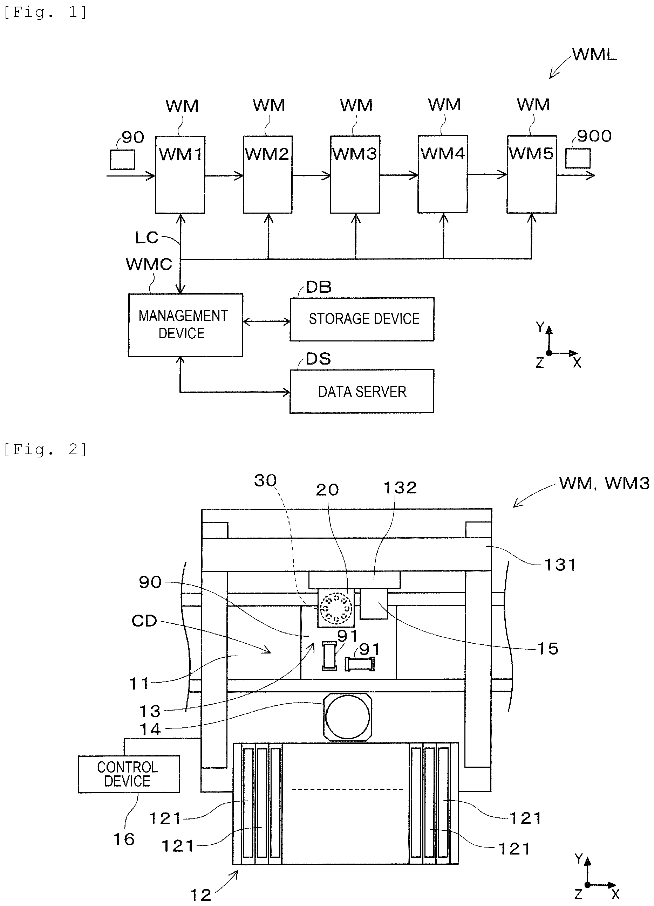

In board work line WML, a predetermined board work is performed with respect to board 90. The type and number of board work machines WM that configure board work line WML are not limited. As shown in Fig. 1, board work line WML of the present embodiment includes multiple (five) board work machines WM of printer WM1, printing inspector WM2, component mounter WM3, reflow furnace WM4, and appearance inspector WM5. Multiple (five) board work machines WM are disposed in the order of printer WM1, printing inspector WM2, component mounter WM3, reflow furnace WM4, and appearance inspector WM5 from the upstream side. Board 90 is conveyed in printer WM1 positioned at the leading end of board work line WML. Then, board 90 is conveyed in the downstream side by a board conveyance device (not shown), of board work line WML, and is conveyed out from appearance inspector WM5 positioned at the end of board work line WML.

Printer WM1 prints solder on board 90 at the mounting position of each of multiple components 91. The solder printed on board 90 is a paste form and has a predetermined viscosity. Solder functions as a bonding material for bonding board 90 and multiple component 91 to be mounted on board 90. Printing inspector WM2 inspects a printing state of the solder which is printed by printer WM1. Component mounter WM3 mounts multiple components 91 on the solder which is printed by printer WM1. Component mounter WM3 may be one, or may be multiple. In a case in which multiple component mounters WM3 are provided, multiple component mounters WM3 can be shared to mount multiple components 91.

Reflow furnace WM4 heats board 90 on which multiple components 91 are mounted by component mounter WM3, causes the solder to melt, and performs soldering. Appearance inspector WM5 inspects a mounting state of multiple components 91 which are mounted by component mounter WM3. Specifically, appearance inspector WM5 recognizes the suitability of each of multiple components 91 that are mounted on board 90, the mounting state (X-axis coordinates, Y-axis coordinates, and mounting angle) of each of multiple components 91, and the like, and sends the recognized information to management device WMC. Thus, board work line WML can convey board 90 in order using multiple (five) board work machines WM to produce board product 900 by performing a production process including an inspection process.

Incidentally, for example, board work line WML can include a functional inspector that is board work machine WM. The functional inspector performs a functional inspection of board 90 soldered by reflow furnace WM4. In addition, for example, depending on the type of board product 900 to be produced, the configuration of board work line WML can be added appropriately, and the configuration of board work line WML can be changed appropriately. Board work line WML can include, for example, board work machine WM such as a buffer device, a board supplying device, a board flipping device, a shield mounting device, an adhesive application device, and an ultraviolet ray irradiation device.

Multiple (five) board work machines WM that configure board work line WML, and management device WMC are electrically connected to each other by communication section LC. Communication section LC may be wired, or may be wireless. Also, as the communication method, various methods can be adopted. In the present embodiment, local area network (LAN) is configured by multiple (five) board work machines WM and management device WMC. Therefore, multiple (five) board work machines WM can communicate with each other via communication section LC. Also, multiple (five) board work machines WM can communicate with management device WMC via communication section LC.

Management device WMC controls multiple (five) board work machines WM configuring board work line WML, and monitors an operation status of board work line WML. Management device WMC stores various control data for controlling multiple (five) board work machines WM. Management device WMC transmits the control data to each of multiple (five) board work machines WM. Each of multiple (five) board work machines WM transmits the operation status and the production status to management device WMC.

Storage device DB is provided in management device WMC. Storage device DB stores the acquired data that is data acquired by board work machine WM related to the board work. For example, various image data captured by board work machine WM are included in the acquired data. Record (log data) of the operation status acquired by board work machine WM is included in the acquired data. A production information server (not shown), or the like can be provided in management device WMC. Various production information related to the production of board 90 can be stored in the production information server. For example, the component data included in the production information includes information regarding the shape of each type of component 91, information regarding the electrical characteristics, information regarding the handling method of component 91, and the like. The inspection results of the inspector, such as printing inspector WM2 and appearance inspector WM5, are included in the production information.

### 1-2. Configuration Example of Component Mounter WM3

Component mounter WM3 mounts multiple components 91 on board 90. As shown in Fig. 2, component mounter WM3 includes board conveyance device 11, component supply device 12, component transfer device 13, part camera 14, board camera 15, and control device 16. Board conveyance device 11 is, for example, configured by a belt conveyor or the like, and conveys board 90 in a conveyance direction (X-axis direction). Board 90 is a circuit board, and at least one of an electronic circuit and an electrical circuit is formed. Board conveyance device 11 positions board 90 at a predetermined position in the machine while conveying board 90 into component mounter WM3. Board conveyance device 11 conveys board 90 outside component mounter WM3 after the mounting process of multiple components 91 by component mounter WM3 is completed.

Component supply device 12 supplies multiple components 91 to be mounted on board 90. Component supply device 12 includes multiple feeders 121 that are provided along the conveyance direction of board 90 (X-axis direction). Each of multiple feeders 121 performs pitch-feeding of a carrier tape (not shown), in which multiple components 91 are accommodated, and supplies components 91 so as to be picked-up at a supply position located on the distal end side of feeder 121. Also, component supply device 12 can supply the relatively large electronic component (lead component) as compared with the chip component or the like in a state of being disposed on a tray.

Component transfer device 13 includes head driving device 131 and moving table 132. Head driving device 131 is configured so as to move moving table 132 in the X-axis direction and the Y-axis direction by a linear motion mechanism. **In** moving table 132, mounting head 20 is provided so as to be attachable and detachable (replaceable) by a clamp member (not shown). Mounting head 20 picks up and hold component 91 supplied by component supply device 12 by using at least one holding member 30, and mounts component 91 on board 90 positioned by board conveyance device 11. For example, a suction nozzle, a chuck, or the like can be used as holding member 30.

As part camera 14 and board camera 15, for example, a digital imaging device having an imaging element can be used. As the imaging element, for example, an image sensor such as a charge coupled device (CCD) or a complementary metal oxide semiconductor (CMOS) can be used. Part camera 14 and board camera 15 perform imaging based on control signals sent from control device 16. The image data captured by part camera 14 and board camera 15 are transmitted to control device 16.

Part camera 14 is fixed to a base of component mounter WM3 such that an optical axis thereof is upward (vertical upward direction) in a Z-axis direction. Part camera 14 can image component 91 held by holding member 30 from below. Board camera 15 is provided on moving table 132 of component transfer device 13 such that an optical axis thereof is downward (vertical downward direction) in the Z-axis direction. Board camera 15 can image board 90 from above.

Control device 16 includes a known central processing unit and storage device, and a control circuit is configured therein (all of which are not shown). The central processing unit (CPU) can perform various arithmetic processing. A first storage device and a second storage device are provided in the storage device. The first storage device is a volatile storage device (RAM: random access memory) and the second storage device is a nonvolatile storage device (ROM: read only memory). Information output from various sensors provided in component mounter WM3, image data, and the like are input to control device 16. Control device 16 sends the control signals to each device based on a control program, a predetermined mounting condition which is determined in advance, and the like.

For example, control device 16 causes board camera 15 to image board 90 that is conveyed in and positioned by board conveyance device 11. Control device 16 performs image processing with respect to the image captured by board camera 15 to recognize a positioning state of board 90. For example, control device 16 can recognize the positioning state of board 90 by obtaining information regarding a positioning reference section (not shown) or the like, which is provided on board 90 through the image processing. Also, control device 16 causes holding member 30 to pick up and hold component 91 supplied by component supply device 12, and causes part camera 14 to image component 91 held in holding member 30. Control device 16 performs the image processing with respect to the image captured by part camera 14 to recognize the holding posture of component 91. For example, control device 16 can recognize the holding posture of component 91 by obtaining information regarding a characteristic portion of the appearance of component 91 or the like through the image processing.

Control device 16 moves holding member 30 toward above a scheduled mounting position that is predetermined by a control program or the like. Further, based on the positioning state of board 90, the holding posture of component 91, and the like, control device 16 corrects the scheduled mounting position and sets the mounting position on which component 91 is actually mounted. The scheduled mounting position and mounting position include a rotation angle in addition to the position (X-axis coordinate and Y-axis coordinate). Control device 16 corrects a target position (X-axis coordinates and Y-axis coordinates) of holding member 30 and the rotation angle in accordance with the mounting position. Control device 16 lowers holding member 30 at the corrected rotation angle at the corrected target position to mount component 91 on board 90. Control device 16 repeats the picking and placing cycle described above to perform the mounting process of mounting multiple components 91 on board 90.

### 1-3. Configuration Example of Data Management Device 80

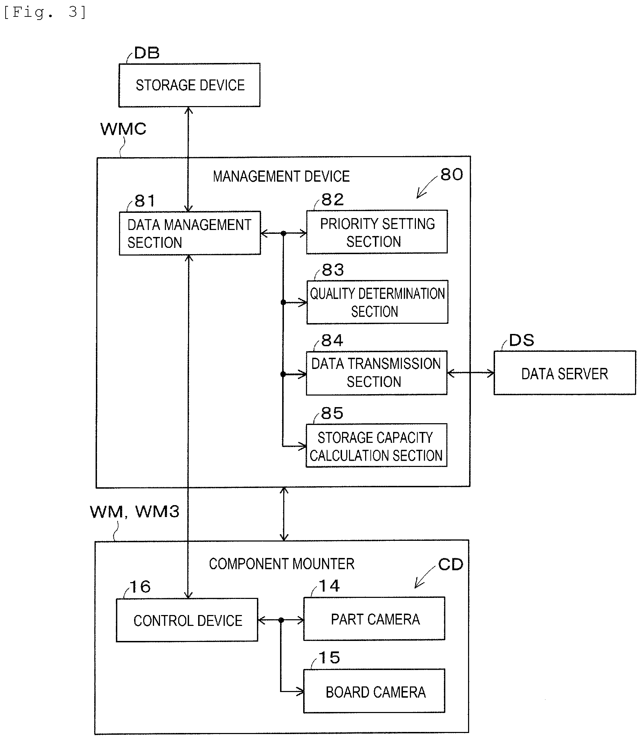

Data management device 80 includes, in a case of regarding as the control blocks, data management section 81 and priority setting section 82. It is preferable that data management device 80 further include at least quality determination section 83 of quality determination section 83 and data transmission section 84. It is preferable that data management device 80 further include storage capacity calculation section 85. Data management device 80 of the present embodiment includes data management section 81, priority setting section 82, quality determination section 83, data transmission section 84, and storage capacity calculation section 85, as shown in Fig. 3. Data management device 80 of the present embodiment is provided in management device WMC, but data management device 80 can be provided in various servers or the like, which store and manage the acquired data.

### 1-3-1. Data Management Section 81

Data management section 81 provides, to the acquired data acquired by board work machine WM that performs a predetermined board work with respect to board 90 in relation to the board work, at least one piece of additional information related to the board work. For example, in a case in which board work machine WM is component mounter WM3 that mounts component 91 to board 90, the conveyance work of board 90, the positioning work of board 90, the pick-up work of component 91, the holding work of component 91, and the mounting work of component 91 are included in the board work. The acquired data is not limited, and need only be data acquired by board work machine WM in relation to the board work. For example, the acquired data may be image data described above, text data (for example, log data), or the like.

As shown in Fig. 2 and Fig. 3, for example, in a case in which board work machine WM is component mounter WM3, it is preferable that component mounter WM3 include imaging device CD having at least one of board camera 15 and part camera 14. Board camera 15 images positioned board 90, and part camera 14 images component 91 which is held by holding member 30. In this case, it is preferable that the acquired data be image data captured by imaging device CD. In general, the image data has a larger data capacity than the text data (log data), and is suitable for storing and managing the acquired data by using data management device 80.

It is preferable that the additional information include at least one of board information, device information, work information, and article information. The board information refers to information regarding board 90. The device information refers to information regarding a usage device used in the board work. The work information refers to information regarding the work condition and work result of the board work. The article information refers to information regarding an article added to board 90 in the board work.

For example, the board information includes information read from an identification code assigned to board 90 (identification information for specifying board 90 or the like), the position information and shape information of the positioning reference section which is provided on board 90, the conveyance speed of board 90, and the like. Also, for example, in a case in which board work machine WM is component mounter WM3, information for specifying component mounter WM3, information for specifying feeder 121, information for specifying the installation position (pick-up position of component 91) of feeder 121 in component supply device 12, information for specifying mounting head 20 and holding member 30, and the like are included in the device information.

Further, for example, the control program stored in control device 16, the predetermined mounting condition, and the like are included in the work information regarding the work condition. For example, the work information regarding the work condition includes version information of the control program, a mounting order of component 91, a circuit number in a case in which component 91 is mounted on board 90, the pick-up position and allowable value of component 91, the mounting position of component 91, the number of feeds and feed correction amount of the carrier tape of feeder 121, and the like. Further, head driving device 131 of component transfer device 13 moves moving table 132 by, for example, a linear motion mechanism, such as a ball screw, in the X-axis direction and the Y-axis direction. In this case, since the degree of thermal expansion differs in accordance with the temperature of the ball screw, control device 16 corrects the movement amount in accordance with the temperature of the ball screw. The correction amount for the thermal expansion of moving table 132 is included in the work information regarding the work condition.

Further, the recognition result (good or bad, error code, and the like) obtained by, for example, performing the image processing with respect to the image captured by board camera 15 to recognize the positioning state of board 90 is included in the work information regarding the work result. The recognition result (good or bad, error code, and the like) obtained by performing the image processing with respect to the image captured by part camera 14 to recognize the holding posture of component 91 is included in the work information regarding the work result. Also, the inspection result (good or bad, error code, and the like) obtained by performing the image processing with respect to the image captured by appearance inspector WM5 to inspect the mounting state of component 91 is included in the work information regarding the work result.

Further, for example, information regarding component 91 mounted on board 90 by component mounter WM3 is included in the article information. For example, the article information includes the circuit number in a case in which component 91 is mounted on board 90, the pick-up position of component 91, the mounting position of component 91, the component type of component 91, the manufacturer of component 91, the manufacturing lot of component 91, the outer shape (external dimension) of component 91, the supply method, and the like. In some cases, the additional information is included in multiple pieces of information including the board information, the device information, the work information, and the article information. For example, the pick-up position of component 91 is included in the device information, and also included in the work information and the article information.

Data management section 81 stores the acquired data in storage device DB in which the maximum storage amount is set for each additional information. Storage device DB can use a nonvolatile storage device that can rewrite data. As storage device DB, for example, a magnetic storage device such as a hard disk drive, an optical storage device such as an optical disk, or the like can be used. Also, the maximum storage amount includes, for example, the maximum storage number and the maximum storage capacity (maximum data capacity) of the acquired data. In storage device DB of the present embodiment, the maximum storage number is set for each additional information. As the method of setting the maximum storage amount, various methods can be adopted. For example, a case is assumed in which the additional information includes the article information that is information regarding at least the component type of component 91 among the component type of component 91, the manufacturer of component 91, and the manufacturing lot of component 91. In this case, it is preferable that data management section 81 set the maximum storage amount to be larger for the component type of component 91 to be mounted on board 90 in a larger number.

For example, a case is assumed in which, in one board 90, a large number of components 91 of component type PA are mounted as compared with component 91 of component type PB. However, for convenience of description, it is assumed that components 91 of component type PA are held one by one by holding member 30 to acquire the image data thereof in the order, and components 91 of component type PB are held one by one by holding member 30 to acquire the image data thereof in the order. In this case, data management section 81 sets the maximum storage number of the image data related to component 91 of component type PA to be large as compared with the maximum storage number of the image data related to component 91 of component type PB. Therefore, data management section 81 can secure a large storage area of the image data related to component 91 of component type PA having a large number to be mounted on board 90 as compared with a storage area of the image data related to component 91 of component type PB having a small number to be mounted on board 90.

The above description can be similarly applied to the manufacturer of component 91 and the manufacturing lot of component 91. For example, data management section 81 can set the maximum storage number to be larger for the acquired data related to the manufacturer of component 91 to be mounted on board 90 in a larger number. In addition, data management section 81 can set the maximum storage number to be larger for the acquired data related to the manufacturing lot of component 91 to be mounted on board 90 in a larger number. In a case in which the image data is acquired by imaging multiple components 91 at the same time, data management section 81 sets the maximum storage number for components 91 to be imaged at the same time on the assumption that one piece of image data is acquired.

Further, for example, a case is assumed in which the work information, which is information related to the work result of the board work, is included in the additional information. In this case, it is preferable that data management section 81 set the maximum storage amount in a case in which the work result of the board work is bad to be large as compared with the maximum storage amount in a case in which the work result of the board work is good. As a result, data management section 81 can secure a large storage area of the acquired data in a case in which the work result is bad, which is relatively likely to be used for dealing with a problem of the board work, as compared with the acquired data in a case in which the work result is good, which is relatively unlikely to be used for dealing with a problem.

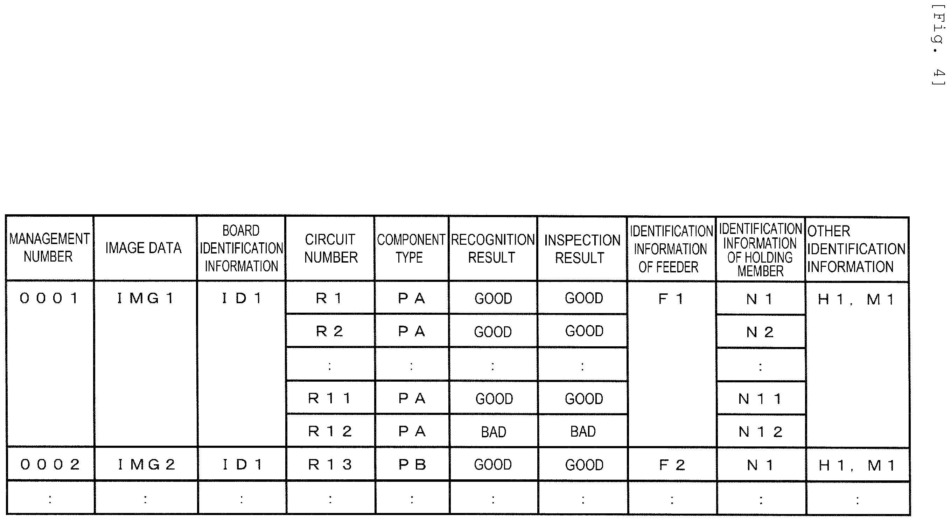

Fig. 4 shows an example of a storage method of the image data acquired by imaging component 91 held by holding member 30 by part camera 14. Image data IMG1 is image data (acquired data) acquired by simultaneously imaging component 91 of component type PA to be mounted on circuit numbers R1 to R12 of board 90 specified by identification information ID1, and is assigned management number 0001 by data management section 81. Component 91 is component 91 that is supplied from feeder 121 specified by identification information F1 (including the installation position), which is provided in component mounter WM3 specified by identification information M1. Further, component 91 is component 91 that is picked up and held by mounting head 20 which includes holding member 30 specified by identification information N1 to N12 and is specified by identification information H1, and is mounted on board 90.

Further, the recognition result obtained by recognizing the holding posture of component 91 held by holding member 30 specified by identification information N1 to N11 is good, and the recognition result obtained by recognizing the holding posture of component 91 held by holding member 30 specified by identification information N12 is bad. Further, the inspection result obtained by inspecting components 91 mounted in circuit numbers R1 to R11 by appearance inspector WM5 is good, and the inspection result obtained by inspecting components 91 mounted in circuit number R12 by appearance inspector WM5 is bad.

Image data IMG2 is image data (acquired data) acquired by imaging component 91 of component type PB mounted on circuit number R13 of board 90 specified by identification information ID1, and is assigned management number 0002 by data management section 81. Component 91 is component 91 supplied from feeder 121 specified by the identification information F2 (including the installation position), which is provided in component mounter WM3 specified by identification information M1. Further, component 91 is component 91 that is picked up and held by mounting head 20 which includes holding member 30 specified by identification information N1 and is specified by identification information H1, and is mounted on board 90. Further, the recognition result obtained by recognizing the holding posture of component 91 held by holding member 30 specified by identification information N1 is good, and the inspection result obtained by inspecting component 91 mounted on circuit number R13 by appearance inspector WM5 is good.

Data management section 81 similarly assigns consecutive management numbers to the image data (acquired data) acquired after image data IMG2, and stores and manages the image data together with the additional information. Data management section 81 can also similarly assign consecutive management numbers to the image data (acquired data) imaged by board camera 15, and store and manage the image data together with the additional information. As shown in Fig. 4, the image data can be continuously stored in storage device DB in the acquisition order. Also, for example, by creating a directory (folder) for each acquisition date, the image data can be stored in the directory (folder).

It is preferable that data management section 81 manage the storage and deletion of the acquired data based on the additional information, and a database be configured in storage device DB. As a result, data management section 81 can easily manage a large amount of acquired data, and can easily search for the acquired data related to desired additional information. As the database, various well-known databases can be adopted. For example, a hierarchical database, a network database, a relational database, or the like can be used as the database, but it is preferable to use a relational database. The database can also be normalized, and an index can be set.

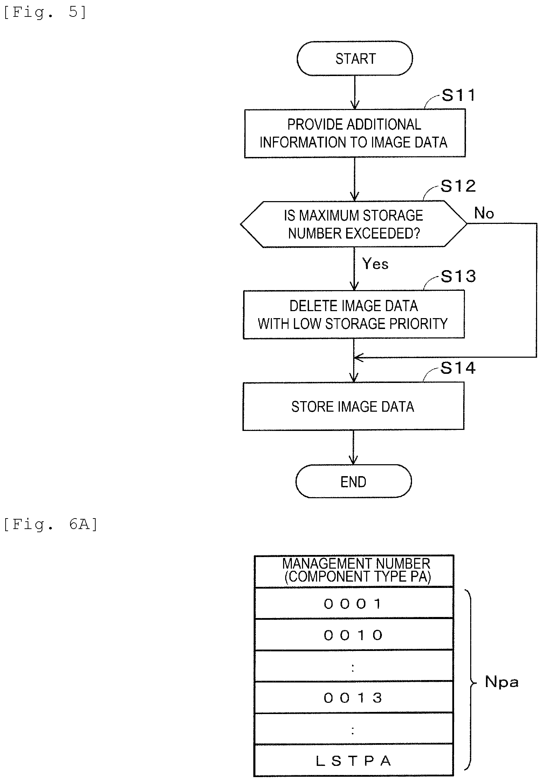

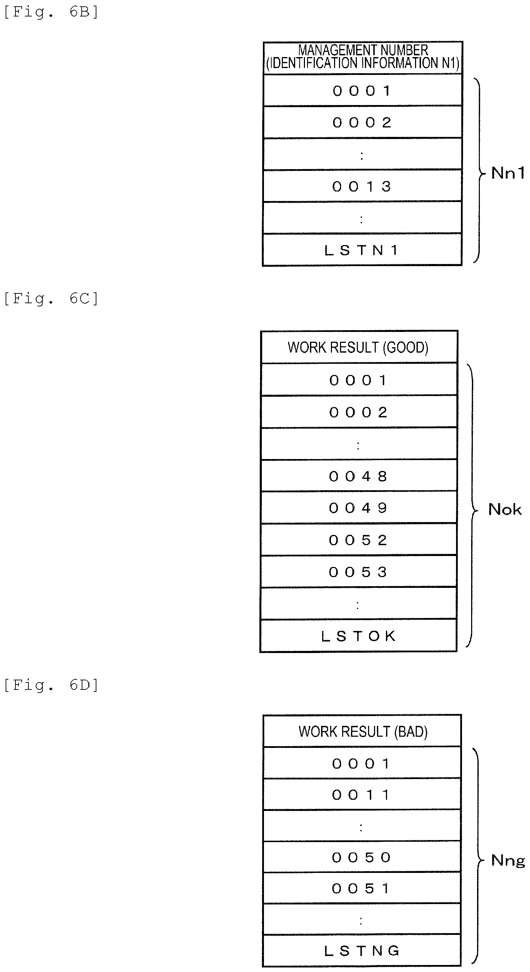

Fig. 5 shows an example of a control procedure performed by data management section 81. Fig. 6A shows an example of a relationship between maximum storage number Npa set for component type PA that is the additional information and the image data (acquired data) stored in storage device DB. Fig. 6B shows an example of a relationship between maximum storage number Nn1 set for holding member 30 specified by identification information N1 that is the additional information and the image data (acquired data) stored in storage device DB. The image data related to component 91 of component type PA is the image data to which management numbers 0001, 0010, ..., 0013, ..., and LSTPA are assigned. The image data related to holding member 30 specified by identification information N1 is the image data to which management numbers 0001, 0002, ..., 0013, ..., and LSTN1 are assigned. The maximum storage number set for component 91 of component type PA is set as maximum storage number Npa, and the maximum storage number set for holding member 30 specified by identification information N1 is set as maximum storage number Nn1.

In a case in which when the acquired data is stored in storage device DB, the maximum storage amount for at least one piece of the additional information is exceeded, data management section 81 delete the acquired data stored in storage device DB in order from the acquired data having a low storage priority set by priority setting section 82. Specifically, data management section 81 provides the additional information described above to the image data acquired by board work machine WM (step S11 shown in Fig. 5). For example, in a case in which the maximum storage amount is the maximum storage number, data management section 81 determines whether or not the maximum storage number for at least one piece of the additional information is exceeded when the image data is stored in storage device DB (step S12). For example, data management section 81 calculates the number of pieces of current image data stored in storage device DB for each provided additional information, adds the number of pieces of image data to be newly stored to each calculated value, and determines whether or not the maximum storage number for each provided additional information is exceeded.

For example, a case is assumed in which when data management section 81 stores one piece of image data in storage device DB, maximum storage number Npa set for component 91 of component type PA is exceeded. In a case in which the maximum storage number is exceeded(Yes in step S12 shown in Fig. 5), data management section 81 deletes the image data stored in storage device DB from the image data having a low storage priority set by priority setting section 82 for the number exceeding the maximum storage number (step S13). For example, it is assumed that the storage priority of the image data is higher as the elapsed time calculated from a point in time when the image data is stored is shorter.

In this case, data management section 81 deletes the image data (image data IMG1 to which management number 0001 shown in Fig. 4 and Fig. 6A is assigned) having the longest elapsed time calculated from the point in time when the image data is stored. Then, data management section 81 stores the image data to be newly stored in storage device DB (step S14), and the control temporarily ends. In a case in which the maximum storage number is not exceeded (No in step S12), data management section 81 stores the image data to be newly stored in storage device DB (step S14), and the control temporarily ends. In a case in which the maximum storage amount is the maximum storage capacity, data management section 81 need only perform, for example, the process described below in step S12, and replace the maximum storage number with the maximum storage capacity (maximum data capacity) in the process after step S13. For example, data management section 81 calculates the storage capacity (data capacity) of the current image data stored in storage device DB for each provided additional information, adds the storage capacity of the image data to be newly stored to each calculated value, and determines whether or not the maximum storage capacity (maximum data capacity) set for each provided additional information is exceeded (alternative process of step S12).

### 1-3-2. Priority Setting Section 82

Priority setting section 82 sets a storage priority that is a priority for continuing storage of the acquired data stored in storage device DB. New acquired data that is relatively short in time stored in storage device DB is likely to include the work result from relatively recent board work. Therefore, it is preferable that priority setting section 82 raise the storage priority as the elapsed time calculated from the point in time when the acquired data is stored is shorter. As a result, data management section 81 can delete the acquired data, while leaving the new acquired data that is stored in storage device DB for a relatively short time, in order from the old data that is stored in storage device DB for a relatively long time.

Further, for example, the manufacturer of board work machine WM may refer to the acquired data stored in storage device DB in a case of dealing with a problem of board work machine WM. The acquired data of which the elapsed time calculated from the point in time of last reference is relatively short is highly likely to be the acquired data used for dealing with the relatively most recent problem. Further, a user of board work machine WM may refer to the acquired data stored in storage device DB in order to check the work status of board work machine WM. The acquired data of which the elapsed time calculated from the point in time of last reference is relatively short is considered to be the acquired data of relatively high interest to the user. Therefore, it is preferable that priority setting section 82 raise the storage priority as the elapsed time calculated from the point in time when the acquired data is last referred to by the inquiry to data management section 81 is shorter.

The above description can be similarly applied to the number of times of reference. For example, the acquired data having a relatively large number of references is highly likely to be used many times for dealing with a problem. Further, the acquired data having a relatively large number of references is considered to be the acquired data having a relatively high interest to the user. Therefore, it is preferable that priority setting section 82 raise the storage priority as the number of times the acquired data is referred to by the inquiry to data management section 81 increases. As described above, data management section 81 can leave desired acquired data and delete the acquired data other than the desired acquired data.

Priority setting section 82 can also set the storage priority by combining the storage priority setting methods described above. Specifically, for example, in a case in which the elapsed time calculated from the point in time when the acquired data is stored is the same, priority setting section 82 can raise the storage priority of the acquired data of which the elapsed time calculated from the point in time when the acquired data is last referred is short. Also, for example, in a case in which the elapsed time calculated from the point in time when the acquired data is stored is the same, priority setting section 82 can raise the storage priority of the acquired data as the number of times the acquired data is referred to increase

As shown in Fig. 4, for example, component 91 of component type PA is picked up and held by holding member 30 specified by identification information N1 and mounted on board 90. Therefore, in a case in which the image data obtained by imaging component 91 is stored in storage device DB, maximum storage number Npa set for component 91 of component type PA shown in Fig. 6A may be exceeded and maximum storage number Nn1 set for holding member 30 specified by identification information N1 shown in Fig. 6B may be exceeded. Therefore, it is preferable that priority setting section 82 set the storage priority of the additional information.

For example, a case is assumed in which the storage priority of the image data related to component 91 of component type PA is set high as compared with the storage priority of the image data related to holding member 30 specified by identification information N1. In this case, data management section 81 deletes, for example, the image data having the smallest number of references (that is, the image data to which management number 0013 shown in Fig. 6B is assigned), which is related to holding member 30 specified by identification information N1 in which the storage priority is set to be low as compared with the storage priority of component 91 of component type PA. Also, data management section 81 deletes the image data to which management number 0013 is assigned, which is related to component 91 of component type PA shown in Fig. 6A, and ensures consistency of the additional information.

A case is assumed in which there is no image data, to which the same management number is assigned, in the image data related to component 91 of component type PA and the image data related to holding member 30 specified by identification information N1. In this case, for example, data management section 81 attempts to delete the image data having the next smallest number of references, which is related to holding member 30 specified by identification information N1 in which the storage priority is set to be low as compared with the storage priority of component 91 of component type PA. In a case in which there is no image data, to which the same management number is assigned, even in a case of repeating the attempt, data management section 81 deletes the image data having the lowest storage priority of the image data related to component 91 of component type PA, and deletes the image data having the lowest storage priority of the image data related to holding member 30 specified by identification information N1.

The storage priority of additional information can be set from various perspectives. For example, priority setting section 82 can also set the storage priority of the additional information based on the determination result of quality determination section 83 described below. Further, priority setting section 82 can set the storage priority by combining the method of setting the storage priority described above and the method of setting the storage priority based on the determination result of quality determination section 83.

### 1-3-3.Quality Determination Section 83

Quality determination section 83 determines the quality of the board work based on the acquired data. For example, in a case in which board work machine WM is component mounter WM3, quality determination section 83 can determine the quality of the positioning work of board 90 by performing the image processing with respect to the image captured by board camera 15 to recognize the positioning state of board 90. In addition, quality determination section 83 can determine the quality of the holding work of component 91 by performing the image processing with respect to the image captured by part camera 14 to recognize the holding posture of component 91. Further, in a case in which board work machine WM is appearance inspector WM5, quality determination section 83 can determine the quality of the mounting work of component 91 by component mounter WM3 by performing the image processing with respect to the image captured by appearance inspector WM5 to recognize the mounting state of component 91.

In either case, in a case in which the recognition result (work result) obtained by performing the image processing with respect to the image to recognize is included in a predetermined range, quality determination section 83 determines that the work result of the board work is good, and in a case in which the recognition result (work result) is not included in the predetermined range, quality determination section 83 determines that the work result of the board work is bad. Here, the acquired data used when quality determination section 83 determines that the quality of the work result of the board work is good is defined as good acquired data, and the acquired data used when quality determination section 83 determines that the work result of the board work is bad is defined as bad acquired data.

The bad acquired data has a high possibility of being used for dealing with a problem of the board work as compared with the good acquired data. Therefore, it is preferable that priority setting section 82 raise the storage priority of the bad acquired data as compared with the storage priority of the good acquired data. Thus, the bad acquired data is likely to remain in storage device DB as compared with the good acquired data.

The priority setting section 82 raise the storage priority of the related good acquired data that is the good acquired data related to the bad acquired data, as compared with the storage priority of the good acquired data other than the related good acquired data. As a result, the related good acquired data is likely to remain in storage device DB as compared with the good acquired data other than the related good acquired data. Data of the good acquired data, which satisfies a predetermined condition is related to the bad acquired data. It is preferable that the predetermined condition be that at least one of a usage device used in the board work, a work condition of the board work, a type of an article added to board 90 in the board work, a manufacturer of the article, and a manufacturing lot of the article is the same.

In a case in which board work machine WM is component mounter WM3, component 91 is mounted on board 90 by using feeder 121, mounting head 20, and holding member 30. For example, depending on the usage device, a problem of the board work may occur. In this case, it is possible to determine whether or not a problem of the board work occurs, depending on the usage device, by confirming the work result of the board work using the usage device.

Specifically, as shown in Fig. 4, it is assumed that the recognition result obtained by recognizing the holding posture of component 91 held by holding member 30 specified by identification information N12 is bad. In this case, it is necessary to confirm the image data related to the usage device (for example, feeder 121 specified by identification information F1, holding member 30 specified by identification information N12, and mounting head 20 specified by identification information H1) used in the holding work of component 91. For example, in the case in which, in the image data related to holding member 30 specified by identification information N12, the ratio of the bad recognition result obtained by recognizing the holding posture of component 91 is higher than that in other holding members 30, it can be said that a problem of the holding work occurs depending on holding member 30 specified by identification information N12.

The above description can be similarly applied to the work condition of the board work described above. For example, in a case in which the ratio of the bad work result in a case of production under the same work condition for a certain period of time is higher than that in other work condition, it can be said that a problem of the board work occurs in accordance with the work condition. The above description can be similarly applied to the types of articles added to board 90 in the board work, the manufacturer of the article, and the manufacturing lot of the article. For example, even in the same type of component 91, the manufacturer of component 91, in a case in which the manufacturing lots of component 91 are different, the outer shape of component 91 (external dimension), color, imaging state, or the like may be slightly different. For example, in a case in which the ratio of bad work result in the case of production using component 91 of the same manufacturing lot is higher than that in other manufacturing lots, it can be said that a problem of the board work occurs depending on the manufacturing lot.

A case is also assumed in which the recognition result obtained by recognizing the holding posture of component 91 held by holding member 30 specified by identification information N12 shown in Fig. 4 is good, and the inspection result obtained by inspecting component 91 mounted on circuit number R12 by appearance inspector WM5 is bad. In this case, for example, at least one of the imaging method (for example, exposure time, diaphragm, irradiation method of illumination) of part camera 14 imaging component 91 held by holding member 30 and the imaging processing method of the image data may not be suitable for component 91. In addition, there is a possibility that the holding work of component 91 is good, but the mounting work of component 91 is bad due to, for example, dropping of component 91. In this manner, it is possible to assume the related good acquired data for the acquired data between multiple board work machines WM.

Fig. 6C shows an example of a relationship between maximum storage number Nok set for the work result (good) that is the additional information and the image data (acquired data) stored in storage device DB. Fig. 6D shows an example of a relationship between maximum storage number Nng set for the work result (bad) that is the additional information and the image data (acquired data) stored in storage device DB. The good acquired data are image data to which management numbers 0001, 0002, ..., 0048, 0049, 0052, 0053, ..., and LSTOK are assigned. The bad acquired data is image data to which management numbers 0001, 0011, ..., 0050, 0051, ..., and LSTNG are assigned. It is assumed that the maximum storage number of good acquired data is the maximum storage number Nok, and the maximum storage number of bad acquired data is the maximum storage number Nng. The storage priority of the bad acquired data is higher than the storage priority of the good acquired data.

The image data to which management numbers 0050 and 0051 are assigned are the bad acquired data. The image data to which management numbers 0048, 0049, 0052, and 0053 are assigned are the good acquired data. As described above, the consecutive management numbers are assigned to the image data in the order of acquisition of the image data. Therefore, Fig. 6C and Fig. 6D show that after the work result is good for a predetermined period of time, the work result becomes bad, and then the work result becomes good again. As described above, a predetermined number of pieces of good acquired data acquired before and after the point in time when the bad acquired data is acquired is, for example, highly likely that the usage device and the like are the same (which satisfies the predetermined condition described above), and can be said to be related good acquired data.

In addition, the acquired data used when quality determination section 83 determines that the work result of the board work is bad, the board work is reattempted, and quality determination section 83 determines that the work result of the board work in a case of reattempt is good is regarded as the good acquired data in a case of reattempt. The good acquired data in a case of reattempt is acquired in the work result of the board work performed due to the fact that the determination is made that the work result of the board work is bad. Therefore, it is preferable that the good acquired data in a case of reattempt be the related good acquired data. As a result, the good acquired data in a case of reattempt is more likely to remain in storage device DB as compared with the good acquired data other than good acquired data in a case of reattempt.

Further, as shown in Fig. 4, image data IMG1 to which management number 0001 is assigned is the image data obtained by simultaneously imaging components 91 which are held by holding members 30 specified by identification information N1 to N12. The recognition result obtained by recognizing the holding postures of components 91 which are held by holding members 30 specified by identification information N1 to N11 is good, and the recognition result obtained by recognizing the holding posture of component 91 held by holding member 30 specified by identification information N12 is bad. As described above, in one piece of acquired data (image data), there is a case in which the data is the good acquired data with respect to the predetermined additional information, but the data is the bad acquired data with respect to other additional information. Therefore, it can be said that the good acquired data related to the predetermined additional information is related to the bad acquired data related to the other additional information, and is the related good acquired data.

### 1-3-4. Data Transmission Section 84

Data transmission section 84 transmits the related good acquired data together with the bad acquired data to data server DS used in a case in which the manufacturer of board work machine WM deals with a problem of board work machine WM.

As data server DS, a nonvolatile storage device that can rewrite data can be used. For example, as data server DS, a magnetic storage device such as a hard disk drive, an optical storage device such as an optical disk, or the like can be used. As shown in Fig. 1 and Fig. 3, data server DS is provided so as to be able to communicate with management device WMC. Further, for example, data server DS can be provided in a customer response department corresponding to an inquiry from the user who uses board work machine WM.

As described above, in a case in which the cause of a problem of the board work is determined, the bad acquired data and the related good acquired data related to the bad acquired data may be necessary. Data management device 80 of the present embodiment includes data transmission section 84, and thus the manufacturer of board work machine WM can deals with a problem of board work machine WM by using the bad acquired data and the related good acquired data related to the bad acquired data.

### 1-3-5. Storage Capacity Calculation Section 85

Storage capacity calculation section 85 calculates a storage capacity required for storage device DB. It is preferable that storage capacity calculation section 85 calculate the storage capacity of storage device DB based on a unit data capacity, the number of pieces of acquired data, the scheduled production number of board products 900 for a predetermined period of time, and the maximum storage amount set for each additional information. Here, the unit data capacity refers to an estimated value of the data capacity per one piece of the acquired data set for each type of board work. The number of pieces of acquired data refers to the number of pieces of the acquired data acquired in a case in which one board product 900 obtained by performing the board work with respect to board 90 is produced.

In a case in which the type of the board work (for example, the holding work of component 91) is decided, the acquisition condition of the acquired data (for example, the imaging condition, the storage condition, and the like of the image data) is roughly decided, and the unit data capacity can be decided for each type of the board work. Therefore, storage capacity calculation section 85 can calculate an estimated value of the storage capacity required for storage device DB by multiplying the unit data capacity, the number of pieces of acquired data, and the scheduled production number of board products 900 for a predetermined period of time together.

Further, in storage device DB, the maximum storage amount is set for each additional information, and thus storage capacity calculation section 85 may calculate the storage capacity required for storage device DB in consideration of the maximum storage amount set for each additional information with respect to the estimated value of the storage capacity required for storage device DB. For example, a case is assumed in which, in one board 90, a large number of components 91 of component type PA are mounted as compared with component 91 of component type PB. However, for convenience of description, it is assumed that components 91 of component type PA are held one by one by holding member 30 to acquire the image data thereof in the order, and components 91 of component type PB are held one by one by holding member 30 to acquire the image data thereof in the order.

In this case, storage capacity calculation section 85 calculates the number of pieces of the acquired data for the image data related to component 91 of component type PA by using maximum storage number Npa set for component 91 of component type PA. In addition, storage capacity calculation section 85 calculates the number of pieces of the acquired data for the image data related to component 91 of component type PB by using the maximum storage number set for component 91 of component type PB. As shown in Fig. 4, in a case in which the image data is acquired by simultaneously imaging multiple components 91, components 91 to be imaged simultaneously are regarded as one piece of image data, and the number of pieces of acquired data is calculated.

### 2. Others

Data management section 81 can also confirm whether or not the maximum storage amount set for each additional information in storage device DB is appropriate. For example, data management section 81 can set threshold value (upper limit value and lower limit value) obtained by multiplying the set maximum storage amount by a predetermined ratio. Data management section 81 can determine that the maximum storage amount is appropriate in a case in which the actual storage amount of the acquired data for the predetermined period of time is included between the upper limit value and the lower limit value. In a case in which the actual storage amount of the acquired data for the predetermined period of time is larger than the upper limit value, data management section 81 can determine that the maximum storage amount is inappropriate (insufficient storage area). In a case in which the actual storage amount of the acquired data for the predetermined period of time is less than the lower limit value, data management section 81 can determine that the maximum storage amount is inappropriate (surplus of the storage area). In a case in which the determination is made that the maximum storage amount is inappropriate, data management section 81 can also increase or decrease the maximum storage amount in accordance with the actual storage amount of the acquired data for the predetermined period of time.

The acquired data, the board work, and board work machine WM which are described above are examples, and are not limited to the above description. For example, imaging device CD can also include a side camera that is capable of imaging component 91 held by holding member 30 from the side. The image data of the image captured by the side camera is included in the acquired data. Further, for example, board work machine WM may be printer WM1 that prints a solder to the mounting position of component 91 on board 90. Also in this case, it is preferable that the additional information include at least one of the board information, the device information, the work information, and the article information which are described above. For example, in the article information, the type, temperature, and viscosity of the solder which is printed on board 90, as well as the printing position, circuit number, and the like of the solder on board 90, are included. The inspection result (good or bad, error code, and the like) obtained by printing inspector WM2, performing the image processing with respect to the image captured and inspecting the printing state of the solder, is included in the work information related to the work result.

### 3. Data Management Method

The above description of data management device 80 can be similarly applied to the data management method. Specifically, the data management method includes a data management step and a priority setting step. The data management step corresponds to the control performed by data management section 81. The priority setting step corresponds to the control performed by priority setting section 82. Also, it is preferable that the data management method include at least a quality determination step among the quality determination step and a data transmission step. The quality determination step corresponds to the control performed by quality determination section 83, and the data transmission step corresponds to the control performed by data transmission section 84. Further, it is preferable that the data management method include a storage capacity calculation step. The storage capacity calculation step corresponds to control performed by storage capacity calculation section 85.

### 4. Example of Effects of Embodiment

With data management device 80, data management section 81 and priority setting section 82 are provided. As a result, data management device 80 can provide at least one piece of additional information related to the board work to the acquired data acquired in relation to the board work, set the maximum storage amount set for each additional information, and store and manage the acquired data. The above description of data management device 80 can be similarly applied to the data management method.

### 5. Reference Embodiment

Data transmission section 84 can be provided in a data management device (hereinafter, referred to as a "second data management device") that stores the acquired data in storage device DB in which the maximum storage amount is not set for each additional information. The second data management device includes a second data management section, quality determination section 83, and data transmission section 84. The second data management section corresponds to data management section 81. However, the second data management section stores, in storage device DB, the acquired data acquired by board work machine WM that performs a predetermined board work with respect to board 90 in relation to the board work. Quality determination section 83 determines the quality of the board work based on the acquired data. The acquired data used when quality determination section 83 determines that the work result of the board work is good is used as the good acquired data, and the acquired data used when quality determination section 83 determines that the work result of the board work is bad is used as the bad acquired data. Data transmission section 84 transmits the bad acquired data and the related good acquired data, which is the good acquired data related to the bad acquired data, together to data server DS used in a case in which the manufacturer of board work machine WM deals with a problem of board work machine WM.

It is preferable that the second data management device further include at least one of priority setting section 82 and storage capacity calculation section 85. In a case in which the second data management device includes priority setting section 82, the second data management section deletes the acquired data stored in storage device DB in order from the acquired data having a low storage priority set by priority setting section 82 in a case in which when the acquired data is stored in storage device DB, the maximum storage amount set in storage device DB is exceeded. The above description of priority setting section 82 and storage capacity calculation section 85 can be similarly applied to the second data management device. However, storage capacity calculation section 85 calculates the storage capacity of storage device DB based on the unit data capacity, the number of pieces of acquired data, and the scheduled production number of board products 900 for a predetermined period of time. The unit data capacity is an estimated value of the data capacity per one piece of the acquired data set for each type of board work. The number of pieces of acquired data is the number of pieces of acquired data acquired when one board product 900 on which a board work has been performed on board 90 is produced. Further, it is preferable that the second data management section manage storage and deletion of the acquired data, and the database be configured in storage device DB. The above description of the second data management device can be similarly applied to the second data management method.

### Reference Signs List

80: data management device, 81: data management section, 82: priority setting section, 83: quality determination section, 84: data transmission section, 85: storage capacity calculation section, WM: board work machine, WM3: component mounter, DB: storage device, DS: data server, 90: board, 91: component, 900: board product, 30: holding member, 14: part camera, 15: board camera, CD: imaging device

## Claims

1. A data management device (80) comprising:
a data management section (81) configured to acquire data acquired by a board work machine (WM) that performs a predetermined board work with respect to a board (90), the acquired data being related to the board work with at least one additional information regarding the board work being provided, by the data management section, to the data acquired by the board work machine, the data management section storing the acquired data in a storage device (DB) to which a maximum storage amount is set for each additional information, wherein the additional information comprises work information that is information related to a work result of the board work, wherein the data acquired by the board work machine (WM) comprises at least one of image data and log data;
a priority setting section (82) configured to set a storage priority that is a priority of continuing storage of the acquired data stored in the storage device,
wherein the data management section stores the acquired data in the storage device, and, in a case in which the maximum storage amount for at least one of the additional information is exceeded, deletes the acquired data stored in the storage device in order from the acquired data having a low storage priority set by the priority setting section; and
a quality determination section (83) configured to determine a quality of the board work based on the acquired data, wherein when the quality determination section (83) determines that the work result of the board work is good, the acquired data is defined as good acquired data, and when the quality determination section (83) determines that the work result of the board work is bad, the acquired data is defined as bad acquired data,
wherein the priority setting section is configured to raise the storage priority of the bad acquired data as compared with the storage priority of the good acquired data,
wherein the priority setting section is configured to raise the storage priority of related good acquired data, that is the good acquired data related to the bad acquired data, as compared with the storage priority of the good acquired data other than the related good acquired data, wherein a predetermined number of pieces of good acquired data acquired before and after the point in time when the bad acquired data is acquired is related to the bad acquired data, and is acquired data for which it is highly likely that at least one of a device used in the board work, a work condition of the board work, a type of an article added to the board in the board work, a manufacturer of the article, and a manufacturing lot of the article is the same.

2. The data management device according to claim 1, wherein the additional information further includes at least one of board information that is information related to the board, device information that is information related to a device used in the board work, and article information that is information related to an article added to the board in the board work.

3. The data management device according to claim 1 or 2, wherein the data management section is configured to manage storage and deletion of the acquired data based on the additional information, and a database is configured in the storage device.

4. The data management device according to claim 1, wherein when the quality determination section determines that the work result of the board work is bad, reattempt of the board work is performed, and when the quality determination section determines that the work result of the board work in a case of reattempt is good, the good acquired data in the case of reattempt is the related good acquired data.

5. The data management device according to any one of claims 1or 4, further comprising a data transmission section configured to transmit the related good acquired data together with the bad acquired data to a data server used in a case in which a manufacturer of the board work machine deals with a problem of the board work machine.

6. The data management device according to any one of claims 1 to 5, further comprising a storage capacity calculation section configured to calculate a storage capacity required for the storage device,
wherein the storage capacity calculation section is configured to calculate the storage capacity of the storage device based on a unit data capacity that is an estimated value of a data capacity per one piece of the acquired data set for each type of the board work, the number of pieces of the acquired data, which is the number of pieces of the acquired data acquired when one board product obtained by performing the board work with respect to the board is produced, a scheduled production number of the board products in a predetermined period of time, and the maximum storage amount set for each additional information.

7. The data management device according to any one of claims 1 to 6,
wherein the board work machine is a component mounter that mounts a component on the board,
the component mounter includes an imaging device that has at least one of a board camera that images the board that is positioned, and a part camera that images the component held by a holding member, and
the acquired data is image data captured by the imaging device.

8. The data management device according to claim 7,
wherein the additional information includes article information that is information regarding at least a component type of the component among the component type of the component, a manufacturer of the component, and a manufacturing lot of the component, and
the data management section is configured to set the maximum storage amount to be larger for the component type of the component to be mounted on the board in a larger number.

9. The data management device according to claim 7 or claim 8,
wherein the additional information includes work information that is information related to a work result of the board work, and
the data management section is configured to set the maximum storage amount in a case in which the work result of the board work is bad to be large as compared with the maximum storage amount in a case in which the work result of the board work is good.

10. A data management method comprising:
a data management step of acquiring data acquired by a board work machine that performs a predetermined board work with respect to a board, the acquired data being related to the board work with at least one additional information regarding the board work being provided, by the data management section, to the data acquired by the board work machine, and storing the acquired data in a storage device in which a maximum storage amount is set for each additional information, wherein the additional information comprises work information that is information related to a work result of the board work, wherein the data acquired by the board work machine (WM) comprises at least one of image data and log data; and
a priority setting step of setting a storage priority that is a priority for continuing storage of the acquired data stored in the storage device,
wherein in the data management step, the acquired data is stored in the storage device, and, in a case in which the maximum storage amount for at least one of the additional information is exceeded, the acquired data stored in the storage device is deleted in order from the acquired data having a low storage priority set in the priority setting step; and
a quality determination step of determining a quality of the board work based on the acquired data, wherein when the quality determination section (83) determines that the work result of the board work is good, the acquired data is defined as good acquired data, and when the quality determination section (83) determines that the work result of the board work is bad, the acquired data is defined as bad acquired data,
wherein the priority setting step comprises raising the storage priority of the bad acquired data as compared with the storage priority of the good acquired data, wherein the priority setting step further comprises raising the storage priority of related good acquired data, that is the good acquired data related to the bad acquired data, as compared with the storage priority of the good acquired data other than the related good acquired data, wherein a predetermined number of pieces of good acquired data acquired before and after the point in time when the bad acquired data is acquired is related to the bad acquired data, and is acquired data for which it is highly likely that that at least one of a device used in the board work, a work condition of the board work, a type of an article added to the board in the board work, a manufacturer of the article, and a manufacturing lot of the article is the same.

## Patentansprüche

1. Datenverwaltungsvorrichtung, (80) umfassend:
einen Datenverwaltungsabschnitt (81), der dazu konfiguriert ist, Daten zu erfassen, die von einer Platinenbearbeitungsmaschine (WM) erfasst werden, die eine vorgegebene Platinenarbeit in Bezug auf eine Platine (90) durchführt, wobei die erfassten Daten mit der Platinenarbeit in Beziehung stehen, wobei mindestens eine zusätzliche Information bezüglich der Platinenarbeit durch den Datenverwaltungsabschnitt zu den von der Platinenbearbeitungsmaschine erfassten Daten bereitgestellt wird, wobei der Datenverwaltungsabschnitt die erfassten Daten in einer Speichervorrichtung (DB) speichert, für die eine maximale Speichermenge für jede zusätzliche Information festgelegt ist, wobei die zusätzliche Information eine Arbeitsinformation umfasst, die eine Information ist, die sich auf ein Arbeitsergebnis der Platinenarbeit bezieht, wobei die von der Platinenbearbeitungsmaschine (WM) erfassten Daten mindestens eines von Bilddaten und Protokolldaten umfassen;
einen Prioritätseinstellungsabschnitt (82), der dazu konfiguriert ist, eine Speicherpriorität festzulegen, bei der es sich um eine Priorität beim Fortsetzen der Speicherung der erfassten Daten handelt, die in der Speichervorrichtung gespeichert werden,
wobei der Datenverwaltungsabschnitt die erfassten Daten in der Speichervorrichtung speichert und in einem Fall, in dem die maximale Speichermenge für mindestens eine der zusätzlichen Informationen überschritten wird, die erfassten Daten, die in der Speichervorrichtung gespeichert sind, in der Reihenfolge beginnend bei den erfassten Daten mit einer niedrigen Speicherpriorität, die durch den Prioritätseinstellungsabschnitt festgelegt wird, löscht; und
einen Qualitätsbestimmungsabschnitt (83), der dazu konfiguriert ist, eine Qualität der Platinenarbeit auf der Grundlage der erfassten Daten zu bestimmen, wobei, wenn der Qualitätsbestimmungsabschnitt (83) bestimmt, dass das Arbeitsergebnis der Platinenarbeit gut ist, die erfassten Daten als gute erfasste Daten definiert werden, und wenn der Qualitätsbestimmungsabschnitt (83) bestimmt, dass das Arbeitsergebnis der Platinenarbeit schlecht ist, die erfassten Daten als schlechte erfasste Daten definiert werden,
wobei der Prioritätseinstellungsabschnitt dazu konfiguriert ist, die Speicherpriorität der schlechten erfassten Daten im Vergleich zu der Speicherpriorität der guten erfassten Daten anzuheben,
wobei der Prioritätseinstellungsabschnitt dazu konfiguriert ist, die Speicherpriorität von zugehörigen guten erfassten Daten, d. h. der guten erfassten Daten, die den schlechten erfassten Daten zugehörig sind, im Vergleich zu der Speicherpriorität der guten erfassten Daten, die nicht die zugehörigen guten erfassten Daten sind, anzuheben, wobei eine vorgegebene Anzahl guter erfasster Datenelemente, die vor und nach dem Zeitpunkt, zu dem die schlechten erfassten Daten erfasst werden, erfasst werden, den schlechten erfassten Daten zugehörig sind, und erfasste Daten sind, für die es sehr wahrscheinlich ist, dass mindestens eines aus einer Vorrichtung, die bei der Platinenarbeit verwendet wird, einer Arbeitsbedingung der Platinenarbeit, einem Typ eines Artikels, der der Platine bei der Platinenarbeit hinzugefügt wird, einem Hersteller des Artikels und einem Fertigungslos des Artikels gleich ist.

2. Datenverwaltungsvorrichtung nach Anspruch 1, wobei die zusätzlichen Informationen ferner mindestens eine der folgenden Informationen enthalten: Platineninformationen, die sich auf die Platine beziehen, Vorrichtungsinformationen, die sich auf eine bei der Platinenbearbeitung verwendete Vorrichtung beziehen, und Artikelinformationen, die sich auf einen Artikel beziehen, der der Platine bei der Platinenbearbeitung hinzugefügt wird.

3. Datenverwaltungsvorrichtung nach Anspruch 1 oder 2, wobei der Datenverwaltungsabschnitt dazu konfiguriert ist, die Speicherung und Löschung der erfassten Daten auf der Grundlage der zusätzlichen Informationen zu verwalten, und eine Datenbank in der Speichervorrichtung konfiguriert ist.

4. Datenverwaltungsvorrichtung nach Anspruch 1, wobei, wenn der Qualitätsbestimmungsabschnitt bestimmt, dass das Arbeitsergebnis der Platinenarbeit schlecht ist, ein erneuter Versuch der Platinenarbeit durchgeführt wird, und wenn der Qualitätsbestimmungsabschnitt bestimmt, dass das Arbeitsergebnis der Platinenarbeit in einem Fall des erneuten Versuchs gut ist die guten erfassten Daten in dem Fall des erneuten Versuchs die zugehörigen guten erfassten Daten sind.

5. Datenverwaltungsvorrichtung nach einem der Ansprüche 1 oder 4, des Weiteren umfassend einen Datenübertragungsabschnitt, der dazu konfiguriert ist, die zugehörigen guten erfassten Daten zusammen mit den schlechten erfassten Daten an einen Datenserver zu übertragen, der in einem Fall verwendet wird, in dem ein Hersteller der Platinenbearbeitungsmaschine ein Problem der Platinenbearbeitungsmaschine behandelt.

6. Datenverwaltungsvorrichtung nach einem der Ansprüche 1 bis 5, des Weiteren umfassend einen Speicherkapazitätsberechnungsabschnitt, der dazu konfiguriert ist, eine für die Speichervorrichtung erforderliche Speicherkapazität zu berechnen,
wobei der Speicherkapazitätsberechnungsabschnitt dazu konfiguriert ist, die Speicherkapazität der Speichervorrichtung auf der Grundlage einer Einheitsdatenkapazität, die ein geschätzter Wert einer Datenkapazität pro einem Element des erfassten Datensatzes für jede Art der Platinenarbeit ist, der Anzahl der Elemente der erfassten Daten, die die Anzahl der Elemente der erfassten Daten ist, welche erfasst werden, wenn ein Platinenprodukt, das durch Ausführen der Platinenarbeit in Bezug auf die Platine erhalten wird, hergestellt wird, einer geplanten Produktionsanzahl der Platinenprodukte in einer vorgegebenen Zeitspanne und der maximalen Speichermenge, die für jede zusätzliche Information festgelegt ist, zu berechnen.

7. Datenverwaltungsvorrichtung nach einem der Ansprüche 1 bis 6,
wobei die Platinenbearbeitungsmaschine eine Komponentenbestückungsmaschine ist, die eine Komponente auf der Platine montiert,
die Komponentenbestückungsmaschine eine Abbildungsvorrichtung enthält, die mindestens eine aus einer Platinenkamera, welche die zu positionierende Platine abbildet, und einer Komponentenkamera, welche die von einem Halteelement gehaltene Komponente abbildet, aufweist, und
die erfassten Daten Bilddaten sind, die von der Abbildungsvorrichtung erfasst werden.

8. Datenverwaltungsvorrichtung nach Anspruch 7,
wobei die zusätzlichen Informationen Artikelinformationen beinhalten, die Informationen bezüglich mindestens eines Komponententyps der Komponente unter dem Komponententyp der Komponente, einem Hersteller der Komponente und einem Fertigungslos der Komponente sind, und
der Datenverwaltungsabschnitt dazu konfiguriert ist, die maximale Speichermenge für den Komponententyp größer einzustellen, der auf der Platine in einer größeren Anzahl montiert werden soll.

9. Datenverwaltungsvorrichtung nach Anspruch 7 oder Anspruch 8,
wobei die zusätzlichen Informationen Arbeitsinformationen enthalten, die sich auf ein Arbeitsergebnis der Platinenarbeit beziehen, und
der Datenverwaltungsabschnitt dazu konfiguriert ist, die maximale Speichermenge in einem Fall, in dem das Arbeitsergebnis der Platinenarbeit schlecht ist, im Vergleich zu der maximalen Speichermenge in einem Fall, in dem das Arbeitsergebnis der Platinenarbeit gut ist, groß einzustellen.

10. Datenverwaltungsverfahren, umfassend:
einen Datenverwaltungsschritt zum Erfassen von Daten, die von einer Platinenbearbeitungsmaschine erfasst werden, welche eine vorgegebene Platinenarbeit in Bezug auf eine Platine durchführt, wobei die erfassten Daten mit der Platinenarbeit in Beziehung stehen, wobei mindestens eine zusätzliche Information bezüglich der Platinenarbeit durch den Datenverwaltungsabschnitt zu den von der Platinenbearbeitungsmaschine erfassten Daten bereitgestellt wird, und zum Speichern der erfassten Daten in einer Speichervorrichtung, für die eine maximale Speichermenge für jede zusätzliche Information festgelegt ist, wobei die zusätzliche Information eine Arbeitsinformation umfasst, die eine Information ist, welche sich auf ein Arbeitsergebnis der Platinenarbeit bezieht, wobei die von der Platinenbearbeitungsmaschine (WM) erfassten Daten mindestens eines von Bilddaten und Protokolldaten umfassen; und
einen Prioritätseinstellungsschritt zum Festlegen einer Speicherpriorität, bei der es sich um eine Priorität beim Fortsetzen der Speicherung der erfassten Daten handelt, die in der Speichervorrichtung gespeichert sind,
wobei in dem Datenverwaltungsschritt die erfassten Daten in der Speichervorrichtung gespeichert werden, und in einem Fall, in dem die maximale Speichermenge für mindestens eine der zusätzlichen Informationen überschritten wird, die erfassten Daten, die in der Speichervorrichtung gespeichert sind, in der Reihenfolge beginnend bei den erfassten Daten mit einer niedrigen Speicherpriorität, die in dem Prioritätseinstellungsschritt festgelegt wird, gelöscht werden; und
einen Qualitätsbestimmungsschritt zum Bestimmen einer Qualität der Platinenarbeit auf der Grundlage der erfassten Daten, wobei, wenn der Qualitätsbestimmungsabschnitt (83) bestimmt, dass das Arbeitsergebnis der Platinenarbeit gut ist, die erfassten Daten als gute erfasste Daten definiert werden, und wenn der Qualitätsbestimmungsabschnitt (83) bestimmt, dass das Arbeitsergebnis der Platinenarbeit schlecht ist, die erfassten Daten als schlechte erfasste Daten definiert werden,
wobei der Prioritätseinstellungsschritt das Anheben der Speicherpriorität der schlechten erfassten Daten im Vergleich zu der Speicherpriorität der guten erfassten Daten umfasst,
wobei der Prioritätseinstellungschritt des Weiteren das Anheben der Speicherpriorität von zugehörigen guten erfassten Daten, d. h. der guten erfassten Daten, die den schlechten erfassten Daten zugehörig sind, im Vergleich zu der Speicherpriorität der guten erfassten Daten, die nicht die zugehörigen guten erfassten Daten sind, umfasst, wobei eine vorgegebene Anzahl guter erfasster Datenelemente, die vor und nach dem Zeitpunkt, zu dem die schlechten erfassten Daten erfasst werden, erfasst werden, den schlechten erfassten Daten zugehörig sind, und erfasste Daten sind, für die es sehr wahrscheinlich ist, dass mindestens eines aus einer Vorrichtung, die bei der Platinenarbeit verwendet wird, einer Arbeitsbedingung der Platinenarbeit, einem Typ eines Artikels, der der Platine bei der Platinenarbeit hinzugefügt wird, einem Hersteller des Artikels und einem Fertigungslos des Artikels gleich ist.

## Revendications

1. Dispositif de gestion de données (80) comprenant :
une section de gestion de données (81) configurée pour acquérir des données acquises par une machine de travail de carte (WM) qui effectue un travail de carte prédéterminé par rapport à une carte (90), les données acquises étant associées au travail de carte avec au moins une information supplémentaire concernant le travail de carte fournie, par la section de gestion de données, aux données acquises par la machine de travail de carte, la section de gestion de données stockant les données acquises dans un dispositif de stockage (DB) pour lequel une quantité de stockage maximale est établie pour chaque information supplémentaire, dans lequel les informations supplémentaires comprennent des informations de travail qui sont des informations associées à un résultat de travail du travail de carte, dans lequel les données acquises par la machine de travail de carte (WM) comprennent des données d'image et/ou des données de journal ;
une section d'établissement de priorité (82) configurée pour établir une priorité de stockage qui est une priorité de continuation du stockage des données acquises stockées dans le dispositif de stockage,
dans lequel la section de gestion de données stocke les données acquises dans le dispositif de stockage, et, dans un cas où la quantité de stockage maximale pour au moins une des informations supplémentaires est dépassée, supprime les données acquises stockées dans le dispositif de stockage dans l'ordre à partir des données acquises ayant une faible priorité de stockage établie par la section d'établissement de priorité ; et
une section de détermination de qualité (83) configurée pour déterminer une qualité du travail de carte sur la base des données acquises, dans lequel, lorsque la section de détermination de qualité (83) détermine que le résultat de travail du travail de carte est bon, les données acquises sont définies comme de bonnes données acquises, et, lorsque la section de détermination de qualité (83) détermine que le résultat de travail du travail de carte est mauvais, les données acquises sont définies comme de mauvaises données acquises,
dans lequel la section d'établissement de priorité est configurée pour augmenter la priorité de stockage des mauvaises données acquises par rapport à la priorité de stockage des bonnes données acquises,
dans lequel la section d'établissement de priorité est configurée pour augmenter la priorité de stockage de bonnes données acquises associées, c'est-à-dire les bonnes données acquises associées aux mauvaises données acquises, par rapport à la priorité de stockage des bonnes données acquises autres que les bonnes données acquises associées, dans lequel un nombre prédéterminé d'éléments de bonnes données acquises qui sont acquises avant et après le moment où les mauvaises données acquises sont acquises est associé aux mauvaises données acquises, et représente des données acquises pour lesquelles il est très probable qu'au moins l'un parmi un dispositif utilisé dans le travail de carte, une condition de travail du travail de carte, un type d'un article ajouté à la carte dans le travail de carte, un fabricant de l'article et un lot de fabrication de l'article est le même.

2. Dispositif de gestion de données selon la revendication 1, dans lequel les informations supplémentaires comprennent en outre des informations de carte qui sont des informations associées à la carte et/ou des informations de dispositif qui sont des informations associées à un dispositif utilisé dans le travail de carte, et/ou des informations d'article qui sont des informations associées à un article ajouté à la carte dans le travail de carte.

3. Dispositif de gestion de données selon la revendication 1 ou 2, dans lequel la section de gestion de données est configurée pour gérer le stockage et la suppression des données acquises sur la base des informations supplémentaires, et une base de données est configurée dans le dispositif de stockage.

4. Dispositif de gestion de données selon la revendication 1, dans lequel, lorsque la section de détermination de qualité détermine que le résultat de travail du travail de carte est mauvais, une nouvelle tentative du travail de carte est effectuée, et, lorsque la section de détermination de qualité détermine que le résultat de travail du travail de carte dans un cas de nouvelle tentative est bon, les bonnes données acquises dans le cas de nouvelle tentative sont les bonnes données acquises associées.

5. Dispositif de gestion de données selon l'une quelconque des revendications 1 ou 4, comprenant en outre une section de transmission de données configurée pour transmettre les bonnes données acquises associées conjointement avec les mauvaises données acquises à un serveur de données utilisé dans un cas où un fabricant de la machine de travail de carte traite un problème de la machine de travail de carte.

6. Dispositif de gestion de données selon l'une quelconque des revendications 1 à 5, comprenant en outre une section de calcul de capacité de stockage configurée pour calculer une capacité de stockage requise pour le dispositif de stockage,
dans lequel la section de calcul de capacité de stockage est configurée pour calculer la capacité de stockage du dispositif de stockage sur la base d'une capacité de données unitaire qui est une valeur estimée d'une capacité de données par élément des données acquises établie pour chaque type de travail de carte, du nombre d'éléments des données acquises, qui est le nombre d'éléments des données acquises qui sont acquises lorsqu'un produit de carte obtenu en effectuant le travail de carte par rapport à la carte est produit, d'un nombre de production programmé des produits de carte dans une période de temps prédéterminée, et de la quantité de stockage maximale établie pour chaque information supplémentaire.

7. Dispositif de gestion de données selon l'une quelconque des revendications 1 à 6,
dans lequel la machine de travail de carte est un dispositif de montage de composant qui monte un composant sur la carte,
le dispositif de montage de composant comprend un dispositif d'imagerie qui a une caméra de carte qui image la carte qui est positionnée et/ou une caméra de pièce qui image le composant maintenu par un élément de maintien, et
les données acquises sont des données d'image capturées par le dispositif d'imagerie.

8. Dispositif de gestion de données selon la revendication 7,
dans lequel les informations supplémentaires comprennent des informations d'article qui sont des informations concernant au moins un type de composant du composant parmi le type de composant du composant, un fabricant du composant et un lot de fabrication du composant, et
la section de gestion de données est configurée pour établir la quantité de stockage maximale comme étant plus grande pour le type de composant du composant à monter sur la carte en plus grand nombre.

9. Dispositif de gestion de données selon la revendication 7 ou la revendication 8,
dans lequel les informations supplémentaires comprennent des informations de travail qui sont des informations associées à un résultat de travail du travail de carte, et
la section de gestion de données est configurée pour établir la quantité de stockage maximale dans un cas où le résultat de travail du travail de carte est mauvais comme étant plus grande par rapport à la quantité de stockage maximale dans un cas où le résultat de travail du travail de carte est bon.

10. Procédé de gestion de données comprenant :
une étape de gestion de données consistant à acquérir des données acquises par une machine de travail de carte qui effectue un travail de carte prédéterminé par rapport à une carte, les données acquises étant associées au travail de carte avec au moins une information supplémentaire concernant le travail de carte fournie, par la section de gestion de données, aux données acquises par la machine de travail de carte, et à stocker les données acquises dans un dispositif de stockage dans lequel une quantité de stockage maximale est établie pour chaque information supplémentaire, dans lequel les informations supplémentaires comprennent des informations de travail qui sont des informations associées à un résultat de travail du travail de carte, dans lequel les données acquises par la machine de travail de carte (WM) comprennent des données d'image et/ou des données de journal ; et
une étape d'établissement de priorité consistant à établir une priorité de stockage qui est une priorité de continuation du stockage des données acquises stockées dans le dispositif de stockage,
dans lequel, dans l'étape de gestion des données, les données acquises sont stockées dans le dispositif de stockage, et, dans un cas où la quantité de stockage maximale pour au moins une des informations supplémentaires est dépassée, les données acquises stockées dans le dispositif de stockage sont supprimées dans l'ordre à partir des données acquises ayant une faible priorité de stockage établie dans l'étape d'établissement de priorité ; et
une étape de détermination de qualité consistant à déterminer une qualité du travail de carte sur la base des données acquises, dans lequel, lorsque la section de détermination de qualité (83) détermine que le résultat de travail du travail de carte est bon, les données acquises sont définies comme de bonnes données acquises, et, lorsque la section de détermination de qualité (83) détermine que le résultat de travail du travail de carte est mauvais, les données acquises sont définies comme de mauvaises données acquises,
dans lequel l'étape d'établissement de priorité comprend l'augmentation de la priorité de stockage des mauvaises données acquises par rapport à la priorité de stockage des bonnes données acquises, dans lequel l'étape d'établissement de priorité comprend en outre l'augmentation de la priorité de stockage de bonnes données acquises associées, c'est-à-dire les bonnes données acquises associées aux mauvaises données acquises, par rapport à la priorité de stockage des bonnes données acquises autres que les bonnes données acquises associées, dans lequel un nombre prédéterminé d'éléments de bonnes données acquises qui sont acquises avant et après le moment où les mauvaises données acquises sont acquises est associé aux mauvaises données acquises, et représente des données acquises pour lesquelles il est très probable qu'au moins l'un parmi un dispositif utilisé dans le travail de carte, une condition de travail du travail de carte, un type d'article ajouté à la carte dans le travail de carte, un fabricant de l'article et un lot de fabrication de l'article est le même.
